# EUROPEAN PATENT SPECIFICATION

(11) **EP 3 688 872 B1**
(45) Date of publication and mention of the grant of the patent: **07.12.2022**
(21) Application number: 17804312.1
(22) Date of filing: 25.09.2017
(51) Int. Cl.: H03K 17/96

(54) **CAPACITIVE TOUCH PANEL UNIT WITH AN INTERNAL CARRIER SHEET**
KAPAZITIVE BERÜHRUNGSTAFELEINHEIT MIT EINEM INTERNEN TRÄGERBLATT
UNITÉ DE PANNEAU TACTILE CAPACITIF AVEC UNE FEUILLE DE SUPPORT INTERNE

(43) Date of publication of application: 05.08.2020
(73) Proprietor: MERIT AUTOMOTIVE ELECTRONICS SYSTEMS S.L.U, 08620 - Barcelona (ES)
(72) Inventor: WOZNIAK, Marek, 81-578 Gdynia (PL); TKACZYK, Mariusz, 42-219 Sosnowiec (PL)
(74) Representative: Lukaszyk, Szymon
(86) International application number: PCT/PL2017/000093
(87) International publication number: WO 2019/059787

(56) References cited:
- WO-A1-2006/130749
- US-A1- 2012 249 458
- US-A1- 2015 305 147
- US-A1- 2016 179 268
- US-A1- 2017 139 511

## Description

The present invention relates to a capacitive touch panel unit of a control system, comprising a cover marked with at least one external activating area, a rigid support disposed at a predetermined distance beneath the cover and provided with an electric interface to connect said unit with other components of the control system.

### Background of the Invention

Capacitive touch panels of this kind are frequently used in automotive industry as panels controlling various components and subsystems of a vehicle. They usually form compact, preassembled units that at the vehicle assembly line are mechanically fixed to the vehicle dashboard and electrically fixed to the vehicle wiring. To this end the support has usually the form of a printed circuit board provided with an edge enabling to electrically connect such a preassembled unit with an appropriate slotted socket, while the capacitive area is usually imprinted on a flexible foil positioned directly beneath the cover.

Publication US2015268756 discloses a multi-area micro-wire structure including a substrate and a micro-wire layer having first and second distinct and separated areas and first and second layer edges, respectively. The second layer edge is different from the first layer edge and the second area is larger than the first area. One or more first micro-wire electrodes and one or more first connection pads are located in the micro-wire layer in the first area. One or more second micro-wire electrodes and one or more second connection pads are located in the micro-wire layer in the second area. Each micro-wire electrode includes one or more electrically connected micro-wires. Each first or second connection pad is located adjacent to the first or second layer edge and electrically connected to a corresponding first or second micro-wire electrode, respectively. In one embodiment the substrate and the micro-wire layer are folded in the spacing area so that the substrate is between the first area and the second areas. In this embodiment the folded spacing portion is cut away by cutting along cut line.

Publication US2017139511 discloses a touch sensor including a sensor sheet with a plurality of sensor electrodes, wires that extend from the sensor electrodes, and a connection portion for connection to a substrate. The sensor sheet is formed with a body portion in which the sensor electrodes are formed, and a tail portion that projects from the body portion and that includes a terminal. A protective layer is stacked on at least a part of the tail portion. A folded portion in which the sensor sheet has been bent permanently is formed in the tail portion on which the protective layer is stacked.

Therefore, it has been the object of the present invention to provide a capacitive touch panel unit, which would be cost efficient and simple to manufacture and assembly.

### Summary of the Invention

A capacitive touch panel unit, of the of the kind mentioned in the outset, according to the present invention comprises an elastomeric carrier sheet arranged between the cover and the support coated with a conductive pattern and having at least one folding line defining a front section disposed at one side of said folding line and a rear section disposed at the other side of said folding line, at least one conductive, capacitive area arranged on said carrier sheet adjoining said cover at an internal side thereof, beneath said activating area and electrically connected with said electric interface of said support, wherein at said front section said conductive pattern comprises said at least one capacitive area, and at said rear section said conductive pattern comprises at least one connecting pad connected with said capacitive area, and wherein said connecting pad is apt to be connected with a connecting pad of said electric interface of said support, while said carrier sheet is folded along said at least one folding line and the capacitive touch panel unit is assembled, wherein the capacitive touch panel unit is assembled when the support is fixed to the cover by fixing elements wherein said front section and said rear section of said carrier sheet are provided with at least one backlit through opening and said rigid support is provided with at least one light source, preferably in the form of a light emitting diode (LED), disposed in said backlit through opening of said folded carrier sheet.

The invention minimizes the number of distinctive parts thus lowering the costs, since the connecting pads cooperate with the rigid support under pretension and no additional connector is required. Assembling is also a simple linear process, as the particular components are assembled one by one without the need of using conventional error-prone stick in (foil) connectors.

Preferably said elastomeric carrier sheet is coated with said conductive pattern by a conductive ink, paint or lacquer in a pad printing, laser printing, ink printing, spray printing or screen printing process.

Preferably said carrier sheet is transparent at least in the area corresponding to said at least one backlit through opening.

Such an elastomeric carrier sheet may be conveniently and cost efficiently manufactured from rubber or silicon, while transparency enables to transfer the backlit to the activating areas.

Preferably the thickness of said carrier sheet is substantially half of the distance between said cover and said support.

Preferably said front section and said rear section of said carrier sheet are connected in the area of said folding line with at least one folding bridge.

Preferably in such a case the thickness of said folding bridge is narrower than the thickness of said front and said rear sections of said carrier sheet.

Preferably said rigid support has a form of a printed circuit board fixed to said cover.

Preferably said conductive pattern further comprises a guarding pattern.

Preferably said at least one backlit opening is covered with a lens, diaphragm and/or filter layer.

Preferably said front section and said rear section of said carrier sheet are provided with projections and recessions matching each other while said carrier sheet is folded along said at least one folding line.

Preferably said front section and/or said rear section of said carrier sheet is provided at least partially with a circumferential sealing flange.

Flanges of this kind facilitate positioning the support layer and the cover and provide additional water and dust protection.

### Brief description of drawings

The invention shall be described and explained below in connection with the attached drawings on which:
Fig. 1 is a schematic perspective, exploded top (Fig. 1a) and bottom (Fig. 1b) view of a capacitive touch panel according to the present invention;
Fig. 2 illustrates an elastic support layer in unfolded state and respectively in an external (Fig. 2a), side (Fig. 2b), internal (Fig. 2c) and bottom (Fig. 2d) view;
Fig. 3 illustrates an elastic support layer in folded state and respectively in a front (Fig. 3a), side (Fig. 3b), rear (Fig. 3c) and bottom (Fig. 3d) view;
Fig. 4 is a schematic perspective view of an elastic support layer in unfolded (Fig. 4a) and folded (Fig. 4b) state; and
Fig. 5 is a schematic cross-sectional view of another embodiment of the capacitive touch panel.

### Detailed description of preferred embodiments

Presented embodiments of a capacitive touch panel unit 1 and 1a according to the present invention may be employed for controlling various components and subsystems of an automotive vehicle.

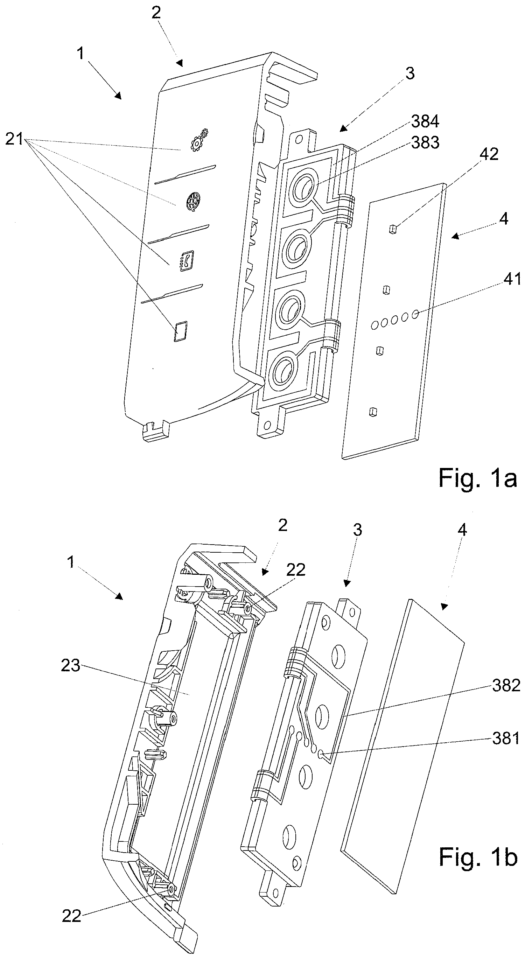

As shown in Fig. 1 the panel unit 1 comprises a plastic cover 2, an elastomeric carrier sheet 3 and a rigid support 4 in a form of a printed circuit board. The cover 2 is marked at its external side with a schematically shown activating areas 21 available to be touched by a driver or a passenger of the vehicle in order to turn on and off or change the functionality of the subsystems of a vehicle such as vehicle settings, navigation, communication, etc. As the activating areas 21 serve solely to distinct the regions of the cover 2 that may be touched (activated), they can be painted with a regular paint, etched, embossed, projected, backlit, illuminated or otherwise marked in a manner known from the state of art.

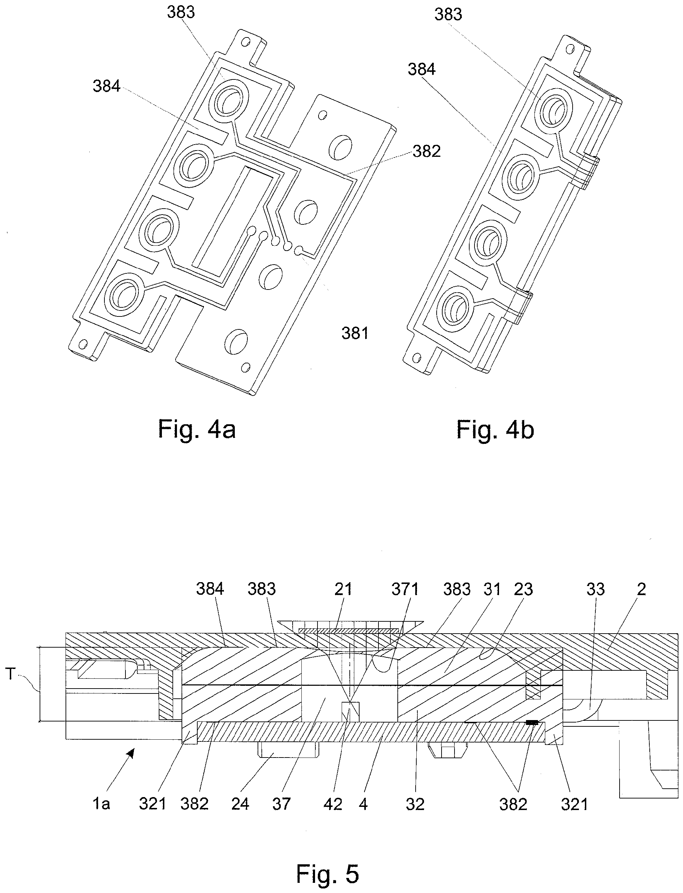

The board 4 is fixed to the cover by means of a number of mounting screws 24 (cf. Fig. 5) screwed inside the mounting holes 22 of the cover 2 in such a way that the distance T (cf. Fig. 5) between the board 4 and internal surface 23 of the cover remains the same. The elastomeric carrier sheet 3 shaped out of an elastomeric sheet is disposed in this space between the board 4 and the cover 2, as shall be explained below.

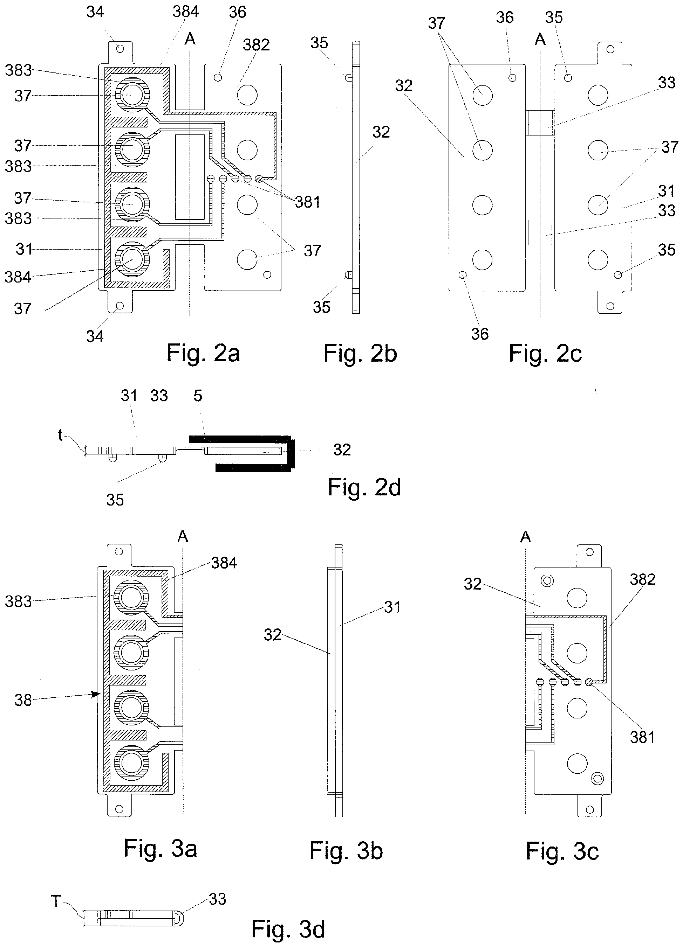

As shown in Figs. 2-4 the elastomeric carrier sheet 3 has a substantially constant thickness t and comprises two substantially rectangular parallel sections: a front section 31 and a rear section 32 connected with each other along a folding line A by means of two folding bridges 33 projected from the longer sides of the sections 31 and 32.

The front section 31 of the presented embodiment comprises two openings 34 for receiving the mounting screws 24 screwed into the mounting holes 22 of the cover 2. The front section 31 also comprises two fixing pins 35 shaped to project perpendicularly to its surface at the internal side thereof and configured to cooperate with two fixing slots 36 shaped as a recessed portion inside the rear section 32. Furthermore the sheet 3 comprises four pairs of backlit through openings 37 disposed in two columns in the front 31 and the rear 32 sections. The functionality of the pins 35, slots 36 and the openings 37 shall be explained below.

The external side of the sheet 3 has been coated with a conductive paint in a pad printing (also known as tampo-printing) process to form a printed pattern 38. At the front section 31 the pattern 38 comprises four ring shaped capacitive areas 383, each surrounding a corresponding backlit opening 37, and a ground, guarding pattern 384 disposed in spaces between the capacitive areas 383. At the rear section 32 the pattern 38 comprises five substantially collinear connecting pads 381, wherein each connecting pad 381 is connected with one of the four capacitive areas 383 or the guarding pattern 384 coated at the front section 31 of the carrier sheet 3 by means of a connection track 382 passing through the folding bridges 33. In the presented embodiment, three tracks 382 corresponding to the two upmost (with respect to the drawing) capacitive areas 383 and the guarding pattern 384 are led through the top folding bridge 33, while the remaining ones through the bottom folding bridge 33.

The carrier sheet 3 is folded prior assembly along the folding line A, using a folding bracket 5 shown in Fig. 2d, to form a compact component having a thickness T being the sum of the thicknesses t of the front 31 or rear 32 sections, as shown in Fig. 3.

To facilitate folding operation the thickness of the folding bridges 33 is narrower than the thickness t of the carrier sheet 3 in its front 31 and rear 32 section areas. After folding the fixing pins 35 are received in fixing slots 36 pretensioning the folded carrier sheet 3.

The folded carrier sheet 3 is fixed between the cover 2 and the printed circuit board 4 with the connecting pads 381 adjoining connecting pads 41 provided at the board 4.

In the presented embodiment the printed circuit board 4 is provided with four light emitting diodes 42 corresponding to the activating areas 21 of the cover 2. Each diode 42 is disposed in the backlit opening 37 of the folded carrier sheet 3, allow for passing a light through the opening 37 for illuminating the internal surface 23 and also the activating areas 21 of the cover 2.

A touch of the cover 2 by a driver or a passenger of the vehicle influences the electric field, the capacitance of which may be easily measured. The guarding pattern 384 enables for elimination of a parasitic capacitance, especially in areas between the particular activating areas 21 of the cover 2.

Backlit openings 37 may be covered with a lens 371, as shown in an embodiment of the panel 1a shown in Fig. 5. Here the lens 371 are shaped in the front section 31 and, as schematically illustrated, extend the cone of light generated by the LED 42 increasing illumination of the activating area 21. Obviously such a lens layer may be configured separately for each backlit opening 37. Furthermore in this embodiment of the panel 1a, the rear section 32 is provided with a sealing flange 321 facilitating positioning the PCB 4.

Obviously the capacitive touch panel unit of the present invention may comprise more than one carrier sheet 3 and each carrier sheer may be provided with more than one folding line A defining multiple front and multiple rear sections 31 and 32.

Furthermore said front and rear sections 31 and 32 do not have to adjoin each other at the internal side of the folded carrier sheet 3 and may be separated by some additional layer, in particular a lens layer in the areas of the backlit openings 37.

Also the connecting pads 41 of the support 4 may be provided with optional projections increasing conductivity.

These and other embodiments of the present invention are therefore merely exemplary. The figures are not necessarily to scale, and some features may be exaggerated or minimized.

### List of reference numerals

- 1.: capacitive touch panel unit
- 2.: cover
21. activating area
22. mounting hole
23. internal surface
24. mounting screw
- 3.: elastomeric carrier sheet
31. front section
32. rear section
321. sealing flange
33. folding bridge
34. mounting opening
35 fixing pin
36. fixing slot
37. backlit opening
371. lens layer
38. printed pattern
381. connecting pad
382. connection track
383. capacitive area
384. guarding pattern
- 4.: rigid support (printed circuit board)
41. connecting pad
42. light source (LED)
- 5.: folding bracket

## Claims

1. A capacitive touch panel unit (1) of a control system,
comprising a cover (2) marked with at least one external activating area (21), a rigid support (4) disposed at a predetermined distance beneath the cover (2) and provided with an electric interface to connect said unit with other components of the control system,
an elastomeric carrier sheet (3) arranged between the cover and the support coated with a conductive pattern (38) and having at least one folding line (A) defining a front section (31) disposed at one side of said folding line (A) and a rear section (32) disposed at the other side of said folding line (A),
at least one conductive, capacitive area (383) arranged on said carrier sheet (3) adjoining said cover at an internal side thereof, beneath said activating area (21) and electrically connected with said electric interface of said support (4), wherein
at said front section (31) said conductive pattern (38) comprises said at least one capacitive area (383),
and at said rear section (32) said conductive pattern (38) comprises at least one connecting pad (381) connected with said capacitive area (383), and wherein
said connecting pad (381) is apt to be connected with a connecting pad (41) of said electric interface of said support (4), while said carrier sheet (3) is folded along said at least one folding line (A) and the capacitive touch panel unit (1) is assembled,
wherein the capacitive touch panel unit is assembled when the support (4) is fixed to the cover by fixing elements
wherein said front section (31) and said rear section (32) of said carrier sheet (3) are provided with at least one backlit through opening (37) and said rigid support (4) is provided with at least one light source (42), preferably in the form of a light emitting diode (LED), disposed in said backlit through opening (37) of said folded carrier sheet (3).

2. The touch panel according to Claim 1, **characterized in that**, said elastomeric carrier sheet (3) is coated with said conductive pattern (38) by a conductive ink, paint or lacquer in a pad printing, laser printing, ink printing, spray printing or screen printing process.

3. The touch panel according to any one of preceding Claims, **characterized in that**, said carrier sheet (3) is transparent at least in the area corresponding to said at least one backlit through opening (37).

4. The touch panel according to any one of preceding Claims, **characterized in that**, the thickness (t) of said carrier sheet (3) is half of the distance (T) between said cover (2) and said support (4).

5. The touch panel according to any one of preceding Claims, **characterized in that**, said front section (31) and said rear section (32) of said carrier sheet (3) are connected in the area of said folding line (A) with at least one folding bridge (33).

6. The touch panel according to Claim 5, **characterized in that**, the thickness of said folding bridge (33) is narrower than the thickness (t) of said front (31) and said rear (32) sections of said carrier sheet (3).

7. The touch panel according to any one of preceding Claims, **characterized in that**, said rigid support (4) has a form of a printed circuit board fixed to said cover (2).

8. The touch panel according to any one of preceding Claims, **characterized in that**, said conductive pattern (38) further comprises a guarding pattern (384).

9. The touch panel according to Claim 1, **characterized in that**, said at least one backlit opening (37) is covered with a lens (371), diaphragm and/or filter layer.

10. The touch panel according to any one of preceding Claims, **characterized in that**, said front section (31) and said rear section (32) of said carrier sheet (3) are provided with projections (35) and recessions (36) matching each other while said carrier sheet (3) is folded along said at least one folding line (A).

11. The touch panel according to any one of preceding Claims, **characterized in that**, said front section (31) and/or said rear section (32) of said carrier sheet (3) is provided at least partially with a circumferential sealing flange (321).

## Patentansprüche

1. Eine kapazitive Berührungsfeldeinheit (1) eines Steuersystems bestehend aus einer Abdeckung (2), die mit mindestens einem externen Aktivierungsbereich (21) versehen ist, einem starren Träger (4), der in einem vorbestimmten Abstand unter der Abdeckung (2) angeordnet und mit einer elektrischen Schnittstelle versehen ist, um die Einheit mit anderen Komponenten des Steuersystems zu verbinden,
einem elastomeren Trägerblatt (3), die zwischen der Abdeckung und dem Träger angeordnet und mit einem leitenden Muster (38) beschichtet ist und mindestens eine Faltlinie (A) aufweist, die einen vorderen Abschnitt (31) definiert, der auf einer Seite der Faltlinie (A) angeordnet ist, und einen hinteren Abschnitt (32) definiert, der auf der anderen Seite der Faltlinie (A) angeordnet ist,
mindestens einem leitfähigen, kapazitiven Bereich (383), der auf dem Trägerblatt (3) an einer Innenseite der Abdeckung unterhalb des Aktivierungsbereichs (21) angeordnet und elektrisch mit der elektrischen Schnittstelle des Trägers (4) verbunden ist,
wobei an dem vorderen Abschnitt (31) das leitende Muster (38) den mindestens einen kapazitiven Bereich (383) umfasst,
und an dem hinteren Abschnitt (32) das leitende Muster (38) mindestens ein mit dem kapazitiven Bereich (383) verbundenes Anschlusspad (381) umfasst, und wobei das Anschlusspad (381) geeignet ist, mit einem Anschlusspad (41) der elektrischen Schnittstelle des Trägers (4) verbunden zu werden, während das Trägerblatt (3) entlang der mindestens einen Faltlinie (A) gefaltet und die kapazitive Berührungsfeldeinheit (1) zusammengesetzt wird,
wobei die kapazitive Berührungsfeldeinheit zusammengebaut wird, wenn der Träger (4) durch Befestigungselemente an der Abdeckung befestigt ist
wobei der vordere Abschnitt (31) und der hintere Abschnitt (32) des Trägerblattes (3) mit mindestens einer hinterleuchteten Durchgangsöffnung (37) versehen sind und der starre Träger (4) mit mindestens einer Lichtquelle (42), vorzugsweise in Form einer Leuchtdiode (LED), versehen ist, die in der hinterleuchteten Durchgangsöffnung (37) des gefalteten Trägerblattes (3) angeordnet ist.

2. Das Berührungsfeld nach Anspruch 1, **dadurch gekennzeichnet, dass** das elastomere Trägerblatt (3) mit dem leitenden Muster (38) durch eine leitfähige Tinte, Farbe oder einen Lack in einem Tampondruck-, Laserdruck-, Farbdruck-, Sprühdruck- oder Siebdruckverfahren beschichtet ist.

3. Das Berührungsfeld nach einem der vorhergehenden Ansprüche, **dadurch gekennzeichnet, dass** das Trägerblatt (3) zumindest in dem Bereich, der der mindestens einen hinterleuchteten Durchgangsöffnung (37) entspricht, transparent ist.

4. Das Berührungsfeld nach einem der vorhergehenden Ansprüche, **dadurch gekennzeichnet, dass** die Dicke (t) des Trägerblattes (3) die Hälfte des Abstandes (T) zwischen der Abdeckung (2) und dem Träger (4) beträgt.

5. Das Berührungsfeld nach einem der vorhergehenden Ansprüche, **dadurch gekennzeichnet, dass** der vordere Abschnitt (31) und der hintere Abschnitt (32) des Trägerblattes (3) im Bereich der Faltlinie (A) mit mindestens einer Faltbrücke (33) verbunden sind.

6. Das Berührungsfeld nach Anspruch 5, **dadurch gekennzeichnet, dass** die Dicke der Faltbrücke (33) schmaler ist als die Dicke (t) des vorderen Abschnitts (31) und des hinteren Abschnitts (32) des Trägerblattes (3).

7. Das Berührungsfeld nach einem der vorhergehenden Ansprüche, **dadurch gekennzeichnet, dass** der starre Träger (4) die Form einer an der Abdeckung (2) befestigten Leiterplatte hat.

8. Das Berührungsfeld nach einem der vorhergehenden Ansprüche, **dadurch gekennzeichnet, dass** das leitende Muster (38) außerdem ein schützendes Muster (384) umfasst.

9. Das Berührungsfeld nach Anspruch 1, **dadurch gekennzeichnet, dass** die mindestens eine hinterleuchtete Öffnung (37) mit einer Linse (371), Blende und/oder Filterschicht abgedeckt ist.

10. Das Berührungsfeld nach einem der vorhergehenden Ansprüche, **dadurch gekennzeichnet, dass** der vordere Abschnitt (31) und der hintere Abschnitt (32) des Trägerblattes (3) mit Vorsprüngen (35) und Vertiefungen (36) versehen sind, die zueinander passen, während das Trägerblatt (3) entlang der mindestens einen Faltlinie (A) gefaltet wird.

11. Das Berührungsfeld nach einem der vorhergehenden Ansprüche, **dadurch gekennzeichnet, dass** der vordere Abschnitt (31) und/oder der hintere Abschnitt (32) des Trägerblattes (3) zumindest teilweise mit einem umlaufenden Dichtungsflansch (321) versehen ist.

## Revendications

1. Une unité de panneau tactile capacitif (1) d'un système de commande,
comprenant un couvercle (2) marqué avec au moins une zone d'activation externe (21), un support rigide (4) disposé à une distance prédéterminée sous le couvercle (2) et muni d'une interface électrique pour connecter ladite unité à d'autres composants du système de commande,
une feuille de support élastomère (3) disposée entre le couvercle et le support, revêtue d'un motif conducteur (38) et ayant au moins une ligne de pliage (A) définissant une section avant (31) disposée d'un côté de ladite ligne de pliage (A) et une section arrière (32) disposée de l'autre côté de ladite ligne de pliage (A),
au moins une zone conductrice, capacitive (383) disposée sur ladite feuille de support (3) adjacente audit couvercle sur un côté interne de celui-ci, sous ladite zone d'activation (21) et connectée électriquement à ladite interface électrique dudit support (4),
dans lequel
au niveau de ladite section avant (31), ledit motif conducteur (38) comprend ladite au moins une zone capacitive (383),
et à ladite section arrière (32), ledit motif conducteur (38) comprend au moins une plage de connexion (381) connectée à ladite zone capacitive (383), et dans lequel ladite plage de connexion (381) est apte à être connectée à une plage de connexion (41) de ladite interface électrique dudit support (4), tandis que ladite feuille de support (3) est pliée le long de ladite au moins une ligne de pliage (A) et l'unité de panneau tactile capacitif (1) est assemblée,
dans lequel l'unité de panneau tactile capacitif est assemblée lorsque le support (4) est fixé au couvercle par des éléments de fixation,
dans lequel ladite section avant (31) et ladite section arrière (32) de ladite feuille de support (3) sont munies d'au moins une ouverture traversante rétroéclairée (37) et ledit support rigide (4) est muni d'au moins une source de lumière (42), de préférence sous la forme d'une diode électroluminescente (DEL), disposée dans ladite ouverture traversante rétroéclairée (37) de ladite feuille de support pliée (3).

2. Le panneau tactile selon la revendication 1, **caractérisé en ce que** ladite feuille de support élastomère (3) est revêtue dudit motif conducteur (38) par une encre, une peinture ou une laque conductrice dans un procédé de tampographie, d'impression laser, d'impression à l'encre, d'impression par pulvérisation ou de sérigraphie.

3. Le panneau tactile selon l'une quelconque des revendications précédentes, **caractérisé en ce que** ladite feuille de support (3) est transparente au moins dans la zone correspondant à ladite au moins une ouverture traversante rétroéclairée (37).

4. Le panneau tactile selon l'une quelconque des revendications précédentes, **caractérisé en ce que** l'épaisseur (t) de ladite feuille de support (3) est la moitié de la distance (T) entre ledit couvercle (2) et ledit support (4).

5. Le panneau tactile selon l'une quelconque des revendications précédentes, **caractérisé en ce que**, ladite section avant (31) et ladite section arrière (32) de ladite feuille de support (3) sont reliées dans la zone de ladite ligne de pliage (A) avec au moins un pont de pliage (33).

6. Le panneau tactile selon la revendication 5, **caractérisé en ce que** l'épaisseur dudit pont de pliage (33) est plus étroite que l'épaisseur (t) desdites sections avant (31) et arrière (32) de ladite feuille de support (3).

7. Le panneau tactile selon l'une quelconque des revendications précédentes, **caractérisé en ce que**, ledit support rigide (4) a la forme d'une carte de circuit imprimé fixée audit couvercle (2).

8. Le panneau tactile selon l'une quelconque des revendications précédentes, **caractérisé en ce que** ledit motif conducteur (38) comprend en outre un motif de garde (384).

9. Le panneau tactile selon la revendication 1, **caractérisé en ce que** ladite au moins une ouverture rétroéclairée (37) est recouverte d'une lentille (371), d'un diaphragme et/ou d'une couche filtrante.

10. Le panneau tactile selon l'une quelconque des revendications précédentes, **caractérisé en ce que**, ladite section avant (31) et ladite section arrière (32) de ladite feuille de support (3) sont pourvues de saillies (35) et de creux (36) s'adaptant les uns aux autres tandis que ladite feuille de support (3) est pliée le long de ladite au moins une ligne de pliage (A).

11. Le panneau tactile selon l'une quelconque des revendications précédentes, **caractérisé en ce que** ladite section avant (31) et/ou ladite section arrière (32) de ladite feuille de support (3) est pourvue au moins partiellement d'une bride d'étanchéité circonférentielle (321).
